(19) Europäisches Patentamt / European Patent Office / Office européen des brevets

(11) **EP 2 388 801 B1**

(12) **EUROPEAN PATENT SPECIFICATION**

(45) Date of publication and mention
of the grant of the patent:
**07.11.2012 Bulletin 2012/45**

(21) Application number: **09841827.0**

(22) Date of filing: **16.03.2009**

(51) Int Cl.:
*H01J 37/317* (2006.01)       *H01J 37/302* (2006.01)

(86) International application number:
**PCT/JP2009/055067**

(87) International publication number:
**WO 2010/106621 (23.09.2010 Gazette 2010/38)**

(54) **MULTI-COLUMN ELECTRON BEAM LITHOGRAPHY SYSTEM AND ELECTRON BEAM ORBIT ADJUSTING METHOD THEREOF**

ELEKTRONENSTRAHLLITHOGRAFIESYSTEM MIT MEHREREN SÄULEN UND VERFAHREN ZUR EINSTELLUNG DER ELEKTRONENSTRAHLBAHN

SYSTÈME MULTI-COLONNE DE LITHOGRAPHIE PAR FAISCEAU D'ÉLECTRONS ET SON PROCÉDÉ DE RÉGLAGE D'ORBITE DU FAISCEAU D'ÉLECTRONS

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**23.11.2011 Bulletin 2011/47**

(73) Proprietors:
• **Advantest Corporation**
  **Tokyo 179-0071 (JP)**
• **Yabe, Takayuki**
  **Tokyo 179-0071 (JP)**

(72) Inventor: **YAMADA, Akio**
**Tokyo 179-0071 (JP)**

(74) Representative: **Tetzner, Michael**
**Anwaltskanzlei Dr. Tetzner**
**Van-Gogh-Straße 3**
**D-81479 München (DE)**

(56) References cited:
WO-A1-2008/120391      JP-A- 5 136 031
JP-A- 5 136 031          JP-A- 6 177 023
JP-A- 2007 184 398       JP-A- 2008 311 581
US-A1- 2006 214 117

EP 2 388 801 B1

## Description

## Technical Field

The present invention relates to a multi-column electron beam lithography apparatus and an electron beam trajectory adjustment method for the same. In particular, the present invention relates to a multi-column electron beam lithography apparatus capable of efficiently and accurately selecting one of character projections formed in respective masks of multiple columns, and to an electron beam trajectory adjustment method for the same.

## Background Art

For the purpose of improving throughput, an electron beam exposure apparatus, which is a typical example of an electron beam lithography apparatus, is provided with a variable rectangular opening or a plurality of stencil mask patterns in a stencil mask, and transfers a desired pattern onto a wafer through exposure by selectively using the opening or patterns with beam deflection.

For example, Japanese Patent Application Publication No. 2004-88071 discloses an electron beam exposure apparatus for character projection lithography as such an exposure apparatus. The character projection lithography is performed as follows. Firstly, a beam is applied to one pattern region, e.g., a 20 $\mu$m $\times$ 20 $\mu$m region, selected by beam deflection from a plurality of stencil patterns, e.g., 100 stencil patterns, disposed on a mask to shape a beam cross section into the shape of a stencil pattern. The beam which has passed through the mask is deflected and bent back by a downstream deflector, reduced at a certain reduction ratio, e.g., 1/10, which is determined depending on the electrooptic system, and transferred onto the surface of a sample. The size of a region on the sample surface which is exposed at a time is, for example, 2 $\mu$m $\times$ 2 $\mu$m. When stencil patterns on the mask are appropriately prepared in accordance with a device pattern to be transferred, the number of necessary exposure shots is greatly reduced, and the throughput is improved, in comparison with the case where only a variable rectangular opening is provided.

Further, there has been proposed (e.g. in US 2006/0214117 A1) a multi-column electron beam exposure apparatus collectively including multiple columns (hereinafter referred to as column cells) each of which is a small-sized column of an exposure apparatus such as described above, and which are arranged over a wafer to perform exposure in parallel. Each of the column cells is equivalent to a column of a single-column electron beam exposure apparatus, and the multi-column apparatus as a whole multiplies an exposure throughput by the number of columns because of parallel processing.

Such an electron beam exposure apparatus has exposure data defining what pattern is exposed at which position on a sample. Signals to be applied to deflectors and a focus corrector are determined to expose a pattern in accordance with the exposure data. Further, position data of a pattern to be selected on a mask is also defined, and a mask is selected in accordance with the position data. The improvement of the throughput in exposure of an electron beam exposure apparatus is subject to the achievement of highly accurate application of an electron beam in accordance with exposure data.

However, even when an electron beam is applied after the signals to be applied to deflectors are determined in accordance with exposure data, the electron beam may not be applied to an accurate position sometimes depending on the deflection efficiencies of the deflectors.

To avoid this, correction data is calculated beforehand so that a deviation in a selected position may not occur in each mask. Japanese Patent Application Publication No. 2000-91225 describes a technique, as a technology relating to this, of calculating correction values according to the differences between patterns to be lithographed and specified patterns. The correction values are calculated based on two type of data including: deflection data corresponding to the positions (pattern data code, PDC) of the respective patterns on a block mask; and position data (shot pattern data, SPD) indicating the positions on a wafer on which the patterns are to be exposed.

After such correction data is calculated, the patterns on the mask can be selected with high accuracy using the data.

However, the calculation of such correction data requires much time and effort. Further, since an exposure apparatus varies with time, the correction data needs to be recalculated regularly. This requires additional time to calculate correction data, and consequently causes a decrease in exposure throughput.

JP 5-136031 A discloses a charged particle beam exposure device comprising first and second mask selective deflectors, first and second bending back deflectors, a stencil mask, and a pattern control unit which controls the deflectors, wherein beam deflection data is created on the basis of a state in which the stencil mask is not installed and a state in which the stencil mask is installed.

**Disclosure of Invention**

The present invention has been made in view of the above-described problems in the conventional art. An object of the present invention is to provide a multi-column electron beam lithography apparatus and an electron beam trajectory adjustment method which are capable of efficiently adjusting an electron beam trajectory.

To achieve the above-described problem in the conventional art, according to a basic embodiment, there is provided a multi-column electron beam lithography apparatus including multiple columns to apply electron beams onto a sample, wherein each of the columns concludes: a stencil mask having a plurality of aperture patterns; a selective deflector provided on an incident side of the stencil mask, and configured to deflect the electron beam to select one of the aperture patterns; a bending back deflector provided on an exit side of the stencil mask, and configured to bend back to an optical axis of the column the electron beam that has passed through the aperture pattern; and an electron beam trajectory adjustment unit configured to: adjust deflection efficiencies of the deflectors, without the stencil mask installed, in such a manner as to allow the electron beam deflected toward any positions in a deflection region by the selective deflector to be applied to the same position on the sample by being bent back by the bending back deflector, and adjust the deflection efficiency of the selective deflector, with the stencil mask installed, in such a manner as to allow the electron beam to be deflected toward any of the aperture patterns of the stencil mask while maintaining a relationship between the adjusted deflection efficiencies of the deflectors.

According to the embodiment, there is provided the multi-column electron beam lithography apparatus, wherein each of the columns further may include: a variable shaping unit provided upstream of the selective deflector and configured to shape a cross section of the electron beam; and a reflected electron detector configured to detect a quantity of electrons reflected from the sample due to irradiation with the electron beam, wherein the electron beam trajectory adjustment unit may include: a mask deflection data correction operation section connected to the selective and bending back deflectors, and configured to correct data on a deflection position on the stencil mask; a mask scan data generation section connected to the mask deflection data correction operation section, and configured to generate data to scan the stencil mask with the electron beam; and a scan waveform analysis section configured to accumulate a reflected electron signal of the reflected electron detector and to analyze a waveform of the reflected electron signal, and without the stencil mask installed, the electron beam trajectory adjustment unit causes the variable shaping unit to shape the electron beam in such a manner as to allow the electron beam to have a cross section smaller than a mark pattern provided on the sample; causes the selective deflector to deflect the electron beam in a plurality of different directions and causes the bending back deflector to bend back each of the electron beams deflected in the plurality of different directions; applies and scans the electron beam onto the mark pattern provided on the sample to detect a position of the mark pattern; and adjusts the deflection efficiencies of the selective and bending back deflectors in such a manner as to allow all the detected positions of the mark pattern to be detected at the same position.

According to the embodiment, there is provided the multi-column electron beam lithography apparatus wherein with the stencil mask installed, the electron beam trajectory adjustment unit may cause the variable shaping unit to shape the electron beam into a beam having a cross section smaller than each of aperture mark patterns for electron beam trajectory adjustment formed on the stencil mask; for each of the multiple aperture mark patterns for electron beam trajectory adjustment formed on the stencil mask, may scan the resultant electron beam based on data generated to allow the electron beam to scan and pass through the aperture mark pattern, and may calculate a positional relationship between the data and the aperture mark pattern for electron beam trajectory adjustment on the stencil mask, on the basis of information on electrons reflected from the target; and may determine the deflection efficiency of the selective deflector to allow the electron beam to select any aperture pattern from all the aperture patterns of the stencil mask.

According to another embodiment, there is provided an electron beam trajectory adjustment method for the multi-column electron beam lithography apparatus. The electron beam trajectory adjustment method according to the another embodiment includes the steps of, in each of the columns: before installation of a stencil mask, determining relative conditions between deflection efficiencies of a selective deflector and a bending back deflector by adjusting the deflection efficiencies of the deflectors in such a manner as to allow the electron beam deflected in any directions to be applied to the same position; installing the stencil mask; and after the installation of the stencil mask, applying the electron beam while maintaining the relative conditions between the deflection efficiencies of the deflectors, and determining the deflection efficiency of the selective deflector to allow the electron beam to select any aperture pattern from all aperture patterns on the stencil mask.

According to the another embodiment, there is provided the electron beam trajectory adjustment method wherein the step of determining the relative conditions between the deflection efficiencies before the installation of the stencil mask may concludes: forming an electron beam having a cross-sectional area smaller than a mark pattern provided on the sample; causing the selective deflector to deflect the electron beam in a plurality of different directions and causing the bending back deflector to bend back each of the electron beams deflected in the plurality of different directions; applying and scanning each of the electron beams onto the mark pattern provided on the sample to detect a position of the mark pattern provided on the sample; and adjusting the deflection efficiencies of the selective and bending back deflectors in such a manner as to allow the electron beams deflected in the different directions and then bent back to detect the same position as a position of the mark pattern provided on the sample, and wherein the step of determining the deflection efficiency of the selective deflector after the installation of the stencil mask may concludes: forming an electron beam having a cross-sectional area smaller than each of aperture mark patterns for electron beam trajectory adjustment which are formed on the stencil mask; generating data to allow the electron beam to scan and pass through each of the aperture mark patterns for electron beam trajectory adjustment; detecting electrons reflected from the sample by scanning the electron beam based on all the generated data; calculating a positional relationship between the data and the aperture mark pattern for electron beam trajectory adjustment on the stencil mask; and

determining the deflection efficiency of the selective deflector to allow the electron beam to select any aperture pattern from all the aperture patterns of the stencil mask.

In the multi-column electron beam lithography apparatus and the electron beam trajectory adjustment method according to the present invention, the deflection efficiency of the deflector involved in the selection of a pattern on the stencil mask is adjusted in a step before the installation of the stencil mask so that the electron beam deflected in any direction before being bent back may be applied to the same position. Further, after the installation of the stencil mask, the deflection efficiency of the selective deflector involved in the selection of the pattern is adjusted so that the pattern on the stencil mask can be accurately selected. This eliminates the necessity of calculating correction data individually for each of the patterns on the stencil mask, and enables efficient electron beam trajectory adjustment.

**Brief Description of the Drawings**

Fig. 1 is a diagram showing the configuration of a multi-column electron beam exposure apparatus;
Fig. 2 is a schematic diagram of column cell controllers in the exposure apparatus of Fig. 1;
Fig. 3 is a diagram showing the configuration of one of column cells in the exposure system of Fig. 1;
Fig. 4 is a view showing one example of a mask pattern;
Fig. 5 is a block diagram showing the configuration of a device to adjust an electron beam trajectory;
Figs. 6A and 6B are views for explaining the outline of electron beam trajectory adjustment;
Fig. 7 is a view for explaining a method of measuring a reflected electron signal by scanning an electron beam over a mark pattern provided on a sample;
Fig. 8 is a view for explaining mask deflection data correction operation sections to select a character projection;
Fig. 9 is a flowchart (part 1) showing one example of an electron beam trajectory adjustment process;
Fig. 10 is a flowchart (part 2) showing one example of an electron beam trajectory adjustment process; and
Fig. 11 is a flowchart (part 3) showing one example of an electron beam trajectory adjustment process.

**Description of the Embodiments**

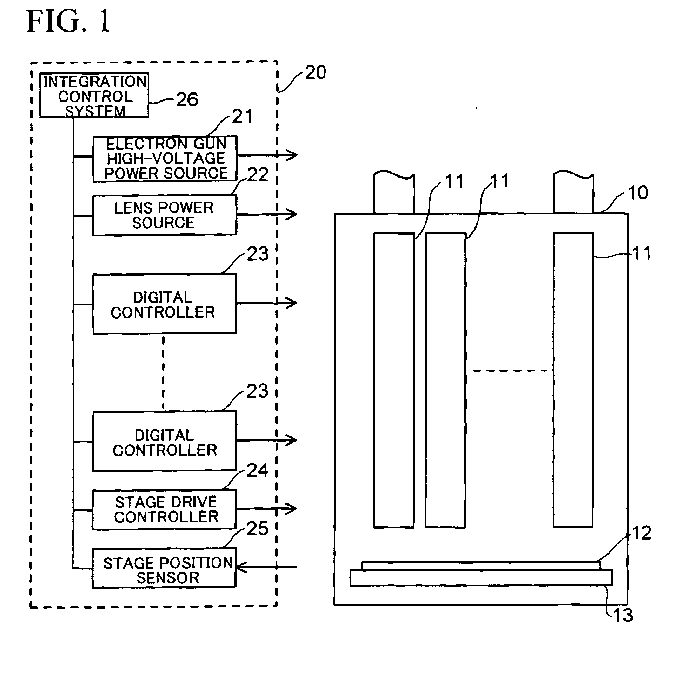

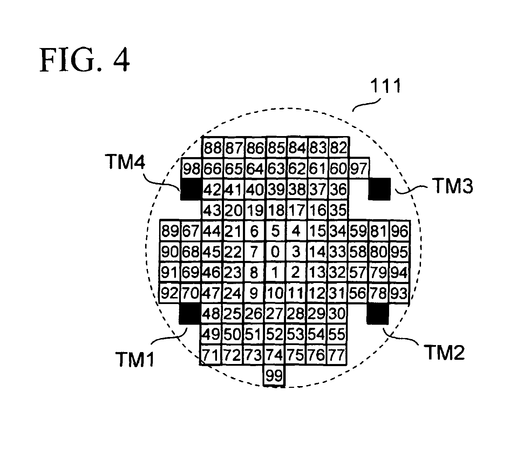

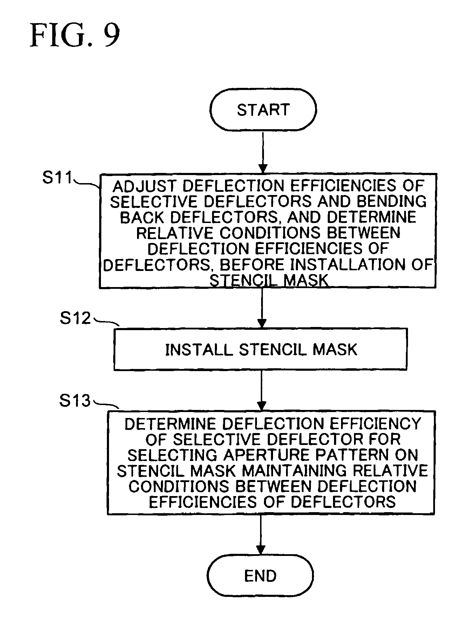

Hereinafter, an embodiment of the present invention is described with reference to the drawings. In this embodiment, a multi-column electron beam exposure apparatus is described as one example of an electron beam lithography apparatus. First, the configuration of the multi-column electron beam exposure apparatus is described with reference to Figs. 1 to 3. Next, the configuration of this apparatus and a technique to adjust an electron beam trajectory is described with reference to Figs. 4 to 8. Then, an electron beam trajectory adjustment method is described with reference to Figs. 9 to 11.

(Configuration of Main Unit of Multi-Column Electron Beam Exposure Apparatus)

Fig. 1 is a schematic diagram showing the configuration of the multi-column electron beam exposure apparatus according to this embodiment.

The multi-column electron beam exposure apparatus is broadly divided into an electron beam column 10 and a controller 20 to control the electron beam column 10. Of these, as to the electron beam column 10, multiple equivalent column cells 11, e.g., 16 equivalent column cells, collectively constitute the entire column. All the column cells 11 include the same units described later. Under the column cells 11, a wafer stage 13 is disposed on which, for example, a 300 mm wafer 12 is mounted.

On the other hand, the controller 20 includes an electron gun high-voltage power source 21, a lens power source 22, digital controllers 23, a stage drive controller 24, and a stage position sensor 25. Of these, the electron gun high-voltage power source 21 supplies power to drive an electron gun of each column cell 11 in the electron beam column 10. The lens power source 22 supplies power to drive electromagnetic lenses of each column cell 11 in the electron beam column 10. Each of the digital controllers 23 is an electric circuit to control each section of the corresponding column cell 11, and outputs a high-speed deflection output and the like. The number of digital controllers 23 to be prepared is equal to the number of column cells 11.

The stage drive controller 24 causes the wafer stage 13 to move based on position information from the stage position sensor 25 so that an electron beam may be applied to a desired position on the wafer 12. The above-described sections 21 to 25 are comprehensively controlled by an integration control system 26 such as a workstation.

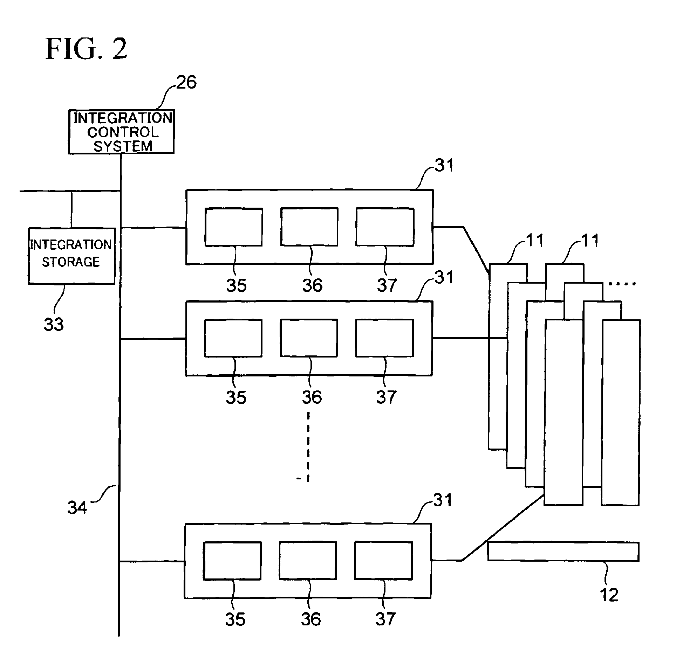

Fig. 2 is a schematic diagram of column cell controllers 31 to control processing relating to deflection data on the multi-column electron beam exposure apparatus. The column cell controllers 31 are possessed by the column cells 11, respectively. The column cell controllers 31 are connected via a bus 34 to the integration control system 26 to control the entire multi-column electron beam exposure apparatus. An integration storage 33 is a hard disk drive, for example, and stores all the data, such as exposure data, which is needed by the column cells. The integration storage 33 is also connected to the integration control system 26 via the bus 34.

Exposure data on a pattern to be exposed on a wafer mounted on the wafer stage 13 is transferred from the integration storage 33 to respective column cell storages 35 of the column cell controllers 31. The transferred exposure data is corrected in correction sections 36 and converted into data necessary for actual exposure in exposure data conversion sections 37.

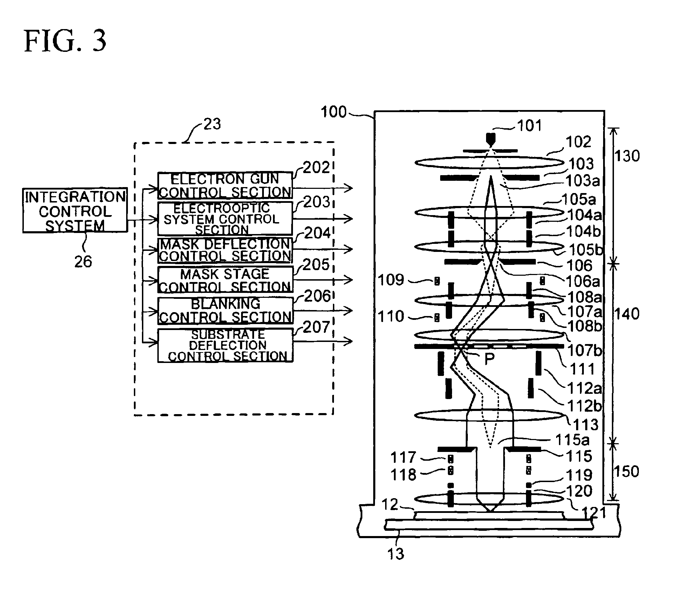

In the above-described multi-column electron beam exposure apparatus, all the column cells 11 have the same column units. Fig. 3 is a schematic diagram showing the configuration of each column cell 11 of Fig. 1 which is used in the multi-column electron beam exposure apparatus.

Each column cell 11 is broadly divided into an exposure unit 100 and a digital controller 23 to control the exposure unit 100. Of these, the exposure unit 100 includes an electron beam generation section 130, a mask deflection section 140, and a substrate deflection section 150.

In the electron beam generation section 130, an electron beam EB generated in an electron gun 101 is subjected to the converging action of a first electromagnetic lens 102, and then passes through a rectangular aperture 103a (first opening) of a beam-shaping mask 103. As a result, the electron beam EB is shaped to have a rectangular cross section.

The electron beam EB shaped into a rectangular shape is imaged onto a second beam-shaping mask 106 by a second electromagnetic lens 105a and a third electromagnetic lens 105b. The electron beam EB is also deflected by a first and second electrostatic deflectors 104a and 104b for variable rectangular shaping and passes through a rectangular aperture 106a (second opening) of the second beam shaping mask 106. The electron beam EB is shaped by the first and second openings.

Then, the electron beam EB is imaged onto a stencil mask 111 by a fourth electromagnetic lens 107a and a fifth electromagnetic lens 107b in the mask deflection section 140. The electron beam EB is also deflected by third and fourth electrostatic deflectors 108a and 108b (also referred to as first and second selective deflectors, respectively) toward a specific pattern P formed in the stencil mask 111, and the cross-sectional shape of the electron beam EB is shaped into the shape of the pattern P. The pattern is also referred to as a character projection (CP) pattern. The electron beam EB is bent to be incident on the stencil mask 111 parallel to the optical axis by the deflector 108b disposed near the fifth electromagnetic lens 107b.

Incidentally, while the stencil mask 111 is fixed to a mask stage, the mask stage is movable in a horizontal plane. For the purpose of using a pattern P located outside the deflection range (beam deflection region) of the third and fourth electrostatic deflectors 108a and 108b, the mask stage is moved so that the pattern P may enter the beam deflection region.

A sixth electromagnetic lens 113 disposed under the stencil mask 111 has a role to make the electron beam EB parallel near a shield 115 by the amount adjustment of the current flowing into the sixth electromagnetic lens 113.

The electron beam EB which has passed through the stencil mask 111 is bent back to the optical axis by the deflecting actions of fifth and sixth electrostatic deflectors 112a and 112b (also referred to as first and second bending back deflectors, respectively). The electron beam EB is bent by the deflector 112b disposed near the sixth electromagnetic lens 113 to be returned to the axis and then travel along the axis.

The mask deflection section 140 includes first and second correction coils 109 and 110 which correct beam deflection aberration produced by the first to sixth electrostatic deflectors 104a, 104b, 108a, 108b, 112a, and 112b.

Then, the electron beam EB passes through an aperture 115a (round aperture) of the shield 115 partially constituting the substrate deflection section 150, and is projected onto a substrate by an electromagnetic projection lens 121. Thus, an image of the pattern of the stencil mask 111 is transferred onto the substrate at a predetermined reduction ratio, e.g., a reduction ratio of 1/10.

The substrate deflection section 150 includes seventh and eighth electromagnetic deflectors 119 and 120 which deflect the electron beam EB so that an image of the pattern of the stencil mask 111 is projected onto a predetermined position on the substrate.

The substrate deflection section 150 further includes third and fourth correction coils 117 and 118 to correct the deflection aberration of the electron beam EB on the substrate.

On the other hand, the digital controller 23 includes an electron gun control section 202, an electrooptic system control section 203, a mask deflection control section 204, a mask stage control section 205, a blanking control section 206, and a substrate deflection control section 207. Of these, the electron gun control section 202 controls the electron gun 101 to control the acceleration voltage, beam irradiation conditions, and the like of the electron beam EB. The electrooptic system control section 203 controls parameters such as the amounts of currents flowing into the electromagnetic lenses 102, 105a, 105b, 107a, 107b, 113, and 121 to adjust the magnifications, focal point positions, and the like of electrooptic systems constituting these electromagnetic lenses. The blanking control section 206 controls the voltage applied to a blanking deflector to deflect the electron beam EB, which has been being generated before the start of exposure, onto the shield 115. As a result, the blanking control section 206 prevents the electron beam EB from being applied onto the substrate before exposure.

The substrate deflection control section 207 controls the voltages applied to the seventh and eighth electrostatic deflectors 119 and 120 to deflect the electron beam EB onto a predetermined position on the substrate. The above-described sections 202 to 207 are comprehensively controlled by the integration control system 26 such as a work station.

In the multi-column electron beam exposure apparatus configured as described above, the column cell controller 31 of each column obtains exposure data from the integration storage 33, converts the exposure data into data necessary for actual exposure, and performs the exposure of the pattern in an exposure region on the wafer which is assigned to the corresponding column cell 11. In particular, as described later, in this embodiment, electron beam trajectory adjustment is performed to find relational expressions with which the voltages supplied to the deflectors can be easily corrected so that the electron beam deflected toward any position in the selection of a pattern formed on the stencil mask may be bent back to the same position.

(Electron Beam Trajectory Adjustment)

Next, electron beam trajectory adjustment is described. The trajectory of the electron beam is deflected by the selective deflectors and then deflected onto the optical axis by the bending back deflectors in order to select a character projection formed in the stencil mask. Fig. 4 shows one example of the stencil mask 111. On the stencil mask I I of Fig. 4, 100 character projections are formed at positions numbered 0 through 99. In four corners of the stencil mask 111, transmission aperture marks TM 1 to TM4 are provided. These transmission aperture marks TM 1 to TM4 are used in electron beam trajectory adjustment performed to make all the character projections formed on the stencil mask 111 capable of being accurately selected.

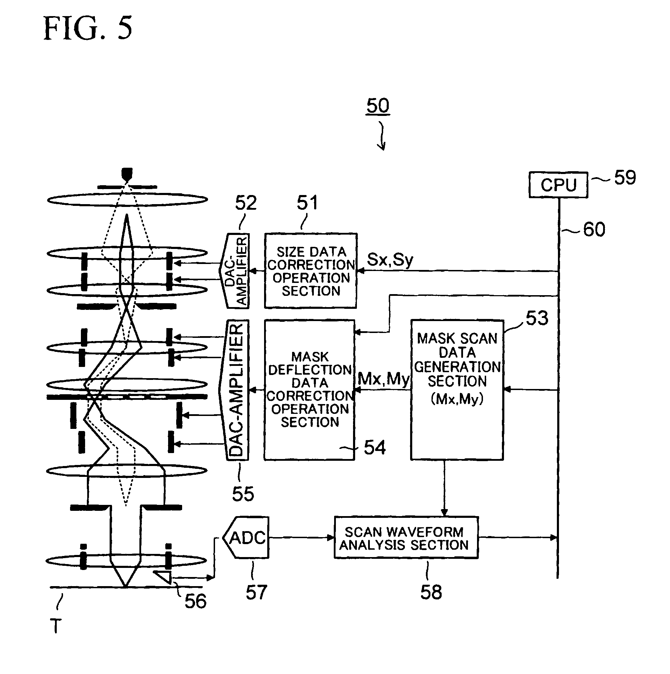

Fig. 5 is a block diagram of a trajectory adjustment processor 50 to carry out an electron beam trajectory adjustment process. Fig. 5 shows a block diagram of the trajectory adjustment processor 50 for one of the columns, and all the columns have the same configurations.

The trajectory adjustment processor 50 basically includes a CPU 59, a size data correction operation section 51, a mask deflection data correction operation section 54, a mask scan data generation section 53, a scan waveform analysis section 58, and a reflected electron detector 56.

The size data correction operation section 51, the mask deflection data correction operation section 54, the mask scan data generation section 53, and the scan waveform analysis section 58 are connected to CPU 59 via the bus 60.

The size data correction operation section 51 corrects data (Sx, Sy) on the size of a variable rectangular beam sent from the CPU 59. The corrected data is sent to a DAC-amplifier 52 to be converted into analog data and amplified by the DAC-amplifier 52, and applied to electrodes of the first and second electrostatic deflectors 104a and 104b.

The mask scan data generation section 53 generates data such as a scan start position, the number of scan points, and a scan pitch to scan the stencil mask 111 for each of the transmission aperture marks formed in the stencil mask 111.

The mask deflection data correction operation section 54 calculates a deflection efficiency for each of the selective deflectors 108a and 108b and the bending back deflectors 112a and 112b. The deflection efficiency means the relationship between the intensity of a signal applied to the deflector and the actual amount of deflection of the electron beam. In accordance with the calculated deflection efficiency, deflection data is converted into analog data and amplified in the DAC-amplifier 55 to be applied to electrodes of the deflectors.

The reflected electron detector 56 detects electrons reflected when the electron beam is applied onto a target T. The quantity of electrons detected by the reflected electron detector 56 is converted into digital quantity by an ADC (AD converter) 57, and outputted to the scan waveform analysis section 58.

The scan waveform analysis section 58 analyzes the quantity of detected reflected electrons, and performs analyses as to whether or not the electron beam has reached the target T, whether or not the electron beam is incident on a predetermined position on the target T, and the like.

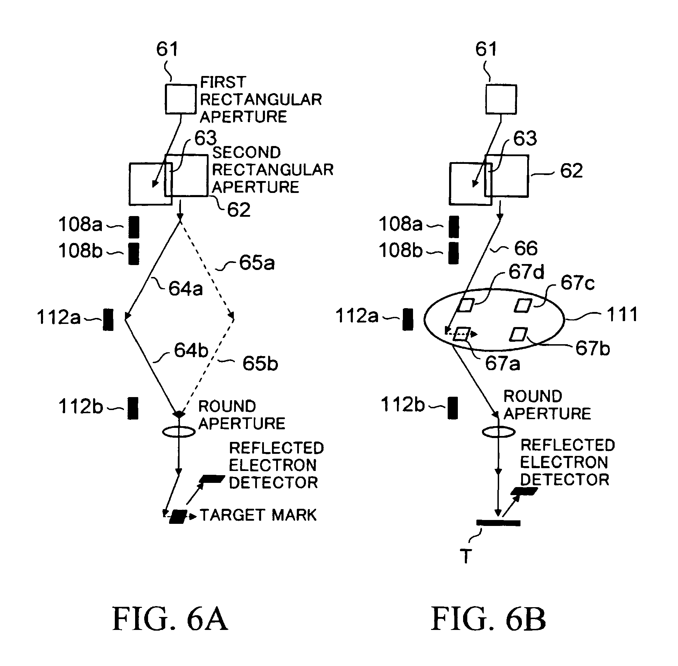

The trajectory adjustment processor 50 configured as described above causes the electron beam to be always bent back to the optical axis regardless of the direction in which the electron beam is deflected in the process of being applied to the target T. Figs. 6A and 6B are conceptual views to explain an electron beam trajectory adjustment method.

Electron beam trajectory adjustment is performed in two steps: before and after the installation of the stencil

6

mask 111.

In the step before the installation of the stencil mask 111, the electron beam deflected in any direction by the selective deflectors 108a and 108b is returned onto the optical axis by the bending back deflectors 112a and 112b. Specifically, a determination is made of relative conditions of voltages applied to the electrodes of each of the selective deflector 108b and the bending back deflectors 112a and 112b with respect to voltages applied to the electrodes of the selective deflector 108a.

Fig. 6A is a view to explain the outline of the electron beam trajectory adjustment before mask installation. The electron beam emitted from the electron gun is shaped into a beam 63 having a small cross-sectional area by first and second rectangular apertures 61 and 62 of a variable shaping unit. Here, the cross-sectional area of the beam 63 is set so that the beam 63, when applied on the target T, can have a cross-sectional area smaller in size than a mark pattern disposed on the target T. For example, in the case where the mark pattern is scanned in an X direction, the beam may be shaped to be narrow in the X direction; meanwhile, in the case where the mark pattern is scanned in a Y direction, the beam may be shaped to be narrow in the Y direction (wide in the X direction). The beam may also be shaped into a square or spot smaller than the mark pattern in both the X and Y directions.

The electron beam shaped as described above is deflected by the deflectors (selective deflectors 108a and 108b and bending back deflectors 112a and 112b) involved in the selection of a transmission aperture pattern on the stencil mask 111, and then the deflected electron beam is bent back.

Relative conditions of four deflectors, i.e., the selective deflectors and the bending back deflectors, are determined so that the electron beam deflected in any direction may be always returned to the same position, e.g., a position on the optical axis, when the electron beam is bent back.

For example, the electron beam is deflected and bent back as indicated by electron beams 64a and 64b in Fig. 6A to pass through the round aperture, and is then scanned over the mark pattern on the target T, and an electron beam irradiation position is detected.

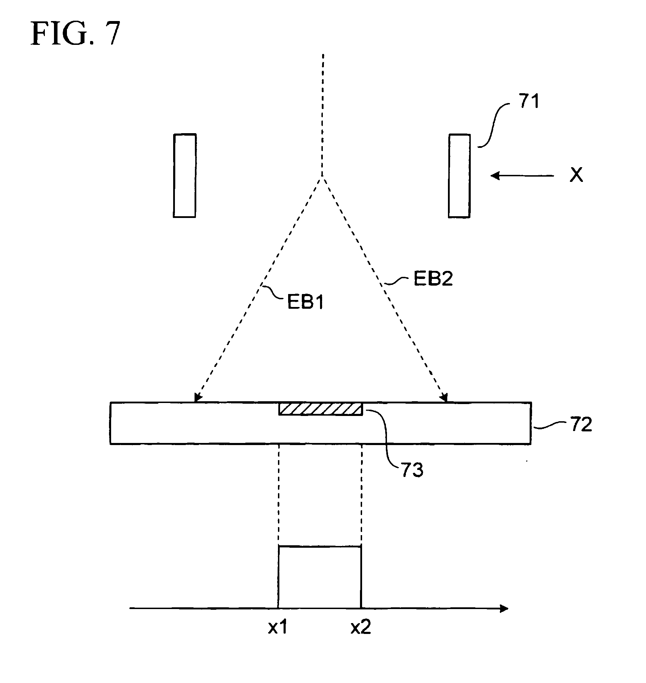

In this irradiation position detection, as shown in Fig. 7, the electron beam is scanned over a mark pattern disposed on a target sample so that the electron beam may move from an electron beam EB 1 to an electron beam EB2 by changing of the voltage applied to a deflector 71 for mark position detection. A mark pattern 73 is made of a material different from that of a substrate 72. Thus, the quantity of reflected electrons generated from the electron beam passing over the mark pattern 73 is made different from the quantity of reflected electrons generated from the electron beam passing over the substrate 72. For example, in the case where the quantity of reflected electrons for the mark pattern 73 is larger than the quantity of reflected electrons for the substrate 72, a waveform is obtained which rises at X1 and falls at X2. A detected position of the mark is stored as a reference mark detection position in association with the value of the voltage applied to the deflector 71 at this time.

Then, the direction of deflection of the electron beam is changed, and similar mark detection is performed. For example, the electron beam is deflected and then bent back as indicated by electron beams 65a and 65b of Fig. 6A toward the opposite side of the optical axis from the electron beams 64a and 64b. Thereafter, similar mark position detection is performed for the electron beam which has passed through the round aperture.

Such deflection and bending back of the electron beam is performed a predetermined number of times, and, every time, an irradiation position deviation is detected and stored. Then, the amounts are calculated by which outputs (coefficients) for the bending back deflectors need to be changed to correct the position deviations.

Hereinafter, a description is made of the case in which the electron beam is deflected toward four positions within a deflection field.

In Figs. 6A and 6B, the voltages applied to electrodes for two directions, i.e., X- and Y-direction electrodes, of the first selective deflector 108a are denoted by (Mx1, My1), and the voltages applied to electrodes of the second selective deflector 108b are denoted by (Mx2, My2). Further, the voltages applied to electrodes of the first bending back deflector 112a are denoted by (Mx3, My3), and the voltages applied to electrodes of the second bending back deflector 112b are denoted by (Mx4, My4). The voltages applied to the electrodes of the first and second selective deflectors 108a and 108b and the first and second bending back deflectors 112a and 112b are defined as follows:

$$Mx1 = Gx1 \times Mx + Rx1 \times My + Hx1 \times Mx \times My$$
$$+ Ox1 + Dx1 \,(Mx, My) \qquad (1)$$

$$My1 = Gy1 \times My + Ry1 \times Mx + Hy1 \times Mx \times My$$
$$+ Oy1 + Dy1 \,(Mx, My) \qquad (2)$$

$$Mx2 = Gx2 \times Mx1 + Rx2 \times My1 + Hx2 \times Mx1 \times My1$$
$$+ Ox2 + Dx2 \,(Mx1, My1) \qquad (3)$$

$$My2 = Gy2 \times My1 + Ry2 \times Mx1 + Hy2 \times Mx1 \times My1$$
$$+ Oy2 + Dy2 \,(Mx1, My1) \qquad (4)$$

$$Mx3 = Gx3 \times Mx1 + Rx3 \times My1 + Hx3 \times Mx1 \times My1$$
$$+ Ox3 + Dx3 \,(Mx1, My1) \qquad (5)$$

$$My3 = Gy3 \times My1 + Ry3 \times Mx1 + Hy3 \times Mx1 \times My1$$
$$+ Oy3 + Dy3 \,(Mx1, My1) \qquad (6)$$

$$Mx4 = Gx4 \times Mx1 + Rx4 \times My1 + Hx4 \times Mx1 \times My1$$
$$+ Ox4 + Dx4 \,(Mx1, My1) \qquad (7)$$

$$My4 = Gy4 \times My1 + Ry4 \times Mx1 + Hy4 \times Mx1 \times My1$$
$$+ Oy4 + Dy4 \,(Mx1, My1) \qquad (8)$$

In the above-described expressions (1) to (8), Gx and Gy are gain correction coefficients, Rx and Ry are rotation correction coefficients, Hx and Hy are keystone correction coefficients, and Ox and Oy are offset adjustment coefficients. It should be noted that these correction coefficients are also collectively called a deflection efficiency.

For these correction coefficients, values are defined beforehand which are adjusted so that the electron beam may pass through the round aperture. However, the electron beam does not always pass through the round aperture with a maximum current to be applied to the same position on the target.

Accordingly, when the electron beam is actually applied, if position deviations occur in mark detection on the target, the coefficients of the expressions are adjusted to prevent the position deviations.

For example, the first selective deflector 108a is given the following four sets of output values (Mx1, My1):

$$(Mx1, My1) = A(\text{-}a, \text{-}a),\ B(a, \text{-}a),\ C(a, a),\ D(\text{-}a, a)$$

It is assumed that the output A(-a, -a) is given to Mx1 and My1. The electron beam passes approximately along a desired path. However, since the coefficients G, R, and H of the deflectors are not completely accurate, there may occur a deviation from the desired path which causes part of the electron beam to fall outside the round aperture to decrease the value of the current and which results in a deviation in the beam irradiation position on the target. To correct this deviation, outputs for the bending back deflectors are adjusted.

The amounts by which outputs for the deflectors need to be changed are denoted by $\Delta Mx3A$, $\Delta My3A$, $\Delta Mx4A$, and $\Delta My4A$. These are amounts corresponding to the magnitude of the deviation from a reference irradiation position.

At this time, substituting values into expressions (5) to (8) yields the following expressions:

$$\Delta Mx3A = Gx3(\text{-}a) + Rx3(\text{-}a) + Hx3(\text{-}a)(\text{-}a) + Ox3$$

$$\Delta My3A = Gy3(-a) + Ry3(-a) + Hy3(-a)(-a) + Oy3$$

$$\Delta Mx4A = Gx4(-a) + Rx4(-a) + Hx4(-a)(-a) + Ox4$$

$$\Delta My4A = Gy4(-a) + Ry4(-a) + Hy4(-a)(-a) + Oy4$$

Similarly, in each of the cases where the outputs B(a, -a), C(a, a), and D(-a, a) are given to Mx1 and My1, the amounts are measured by which outputs for the bending back deflectors need to be changed from the values outputted based on the original coefficients so that the value of the current may be changed back to the maximum and that the irradiation position may be changed back to the reference irradiation position. For B(a, -a), the amounts are denoted by ΔMx3B, ΔMy3B, ΔMx4B, and ΔMy4B, and the following relationship is obtained:

$$\Delta Mx3B = Gx3(a) + Rx3(-a) + Hx3(a)(-a) + Ox3$$

$$\Delta My3B = Gy3(-a) + Ry3(a) + Hy3(a)(-a) + Oy3$$

$$\Delta Mx4B = Gx4(a) + Rx4(-a) + Hx4(a)(-a) + Ox4$$

$$\Delta My4B = Gy4(-a) + Ry4(a) + Hy4(a)(-a) + Oy4$$

For C(a, a), the amounts are denoted by ΔMx3C, ΔMy3C, ΔMx4C, and ΔMy4C, and the following relationship is obtained:

$$\Delta Mx3C = Gx3(a) + Rx3(a) + Hx3(a)(a) + Ox3$$

$$\Delta My3C = Gy3(a) + Ry3(a) + Hy3(a)(a) + Oy3$$

$$\Delta Mx4C = Gx4(a) + Rx4(a) + Hx4(a)(a) + Ox4$$

$$\Delta My4C = Gy4(a) + Ry4(a) + Hy4(a)(a) + Oy4$$

For D(-a, a), the amounts are denoted by ΔMx3D, ΔMy3D, ΔMx4D, and ΔMy4D, and the following relationship is obtained:

$$\Delta Mx3D = Gx3(-a) + Rx3(a) + Hx3(-a)(a) + Ox3$$

$$\Delta My3D = Gy3(a) + Ry3(-a) + Hy3(-a)(a) + Oy3$$

$$\Delta Mx4D = Gx4(-a) + Rx4(a) + Hx4(-a)(a) + Ox4$$

$$\Delta My4D = Gy4(a) + Ry4(-a) + Hy4(-a)(a) + Oy4$$

From the above-described 16 expressions, 16 coefficients (Gx3, Rx3, Hx3, Ox3, Gy3, Ry3, Hy3, Oy3, Gx4, Rx4, Hx4, Ox4, Gy4, Ry4, Hy4, and Oy4) are calculated.

As described above, in the step before the installation of the stencil mask 111, for the four deflectors involved in the selection of a pattern formed on the stencil mask 111, a relative relationship between the deflectors is obtained so that the electron beam may be always applied to the same position regardless of the direction in which the electron beam is deflected before being bent back.

Next, a description is made of electron beam trajectory adjustment which is performed after the installation of the stencil mask 111 to enable high-accuracy selection of a pattern on the stencil mask 111.

The selection of a pattern on the stencil mask 111 is performed by the first and second selective deflectors 108a and 108b. Since relative conditions of each of the second selective deflector 108b and the first and second bending back deflectors 112a and 112b with respect to the first selective deflector 108a are determined in accordance with Fig. 6A, determination of the voltage to be applied to the first selective deflector 108a causes the electron beam to be applied to the same position on the target regardless of which pattern on the stencil mask 111 is selected. The voltages (Mx1, My1) applied to electrodes for two directions, i.e., X- and Y-direction electrodes, of the first selective deflector 108a are expressed by expression (1) and (2).

Fig. 6B shows the outline of the electron beam trajectory adjustment which enables high-accuracy selection of a pattern on the stencil mask 111. As in Fig. 6A, the electron beam is shaped by the first and second rectangular apertures 61 and 62 of the variable shaping unit to have a small cross section. The electron beam is shaped so that the cross-sectional area of the beam applied onto the stencil mask 111 may be smaller than the area of each of the transmission aperture marks (67a to 67d) for pattern position detection formed on the stencil mask 111.

The electron beam shaped as described above is scanned in accordance with the mask scan data of the trajectory adjustment processor 50 to pass over a transmission aperture mark of the stencil mask 111.

Mask scan data (Mx, My) is defined for each of several transmission aperture mark patterns provided on the stencil mask 111. A scan start point (M0x, M0y), the number (Nx, Ny) of scan points, and scan pitches (PMx, PMy) are defined so that the transmission aperture mark pattern may be included. A scan is started from the scan start point (M0x, M0y) and performed at (Nx, Ny) points with the scan pitches (PMx, PMy).

The mask scan data (Mx, My) is sent from the mask scan data generation section 53 to the mask deflection data correction operation section 54 every predetermined timing. A scan is performed on the stencil mask 111 in accordance with mask scan data corrected in the mask deflection data correction operation section 54.

When the electron beam is scanned in accordance with the mask scan data, the electron beam reaches the target T upon moving to the opening 67a. At this time, electrons reflected from the target T are detected by the reflected electron detector 56. When the electron beam is further scanned to pass the opening 67a, the electron beam does not reach the target, and a detection signal of the reflected electron detector 56 becomes zero.

For example, the following is assumed: when irradiation (scan) is started from the scan start point (M0x, M0y) and performed at Nx=500 points with the scan pitch PMx in the X direction, reflected electrons are detected at the position of the 120th point, and no reflected electrons are detected when the electron beam has passed the 300th point. The value of Mx corresponding to the position of the 120th point is stored as a voltage for an aperture mark selection position.

A synchronization signal adapted to the above-described scan is sent from the mask scan data generation section 53 to the scan waveform analysis section 58. The scan waveform analysis section 58 finds the relationship between the position where reflected electrons have been detected and the corresponding mask scan data (data corresponding to voltage) from the waveform of a reflected electron signal.

To scan each of the four transmission aperture marks on the mask in the X and Y directions yields eight expressions obtained by substituting actually measured values into expressions (1) and (2). At this time, the data is passed to the CPU 59. The CPU 59 calculates eight deflection correction coefficients (Gx1, Gy1, Rx1, Ry1, Hx1, Hy1, Ox1, and Oy1) from the eight expressions, and sends the eight deflection correction coefficients to the mask deflection data correction operation section 54. These deflection correction coefficients are calculated from the eight expressions obtained by using as the left-hand sides of expressions (1) and (2) the differences between the detected values of position coordinates (positions of the transmission aperture marks) and the actual positions of the transmission aperture marks, and substituting the corresponding values of the mask scan data into (Mx, My) of the right-hand side.

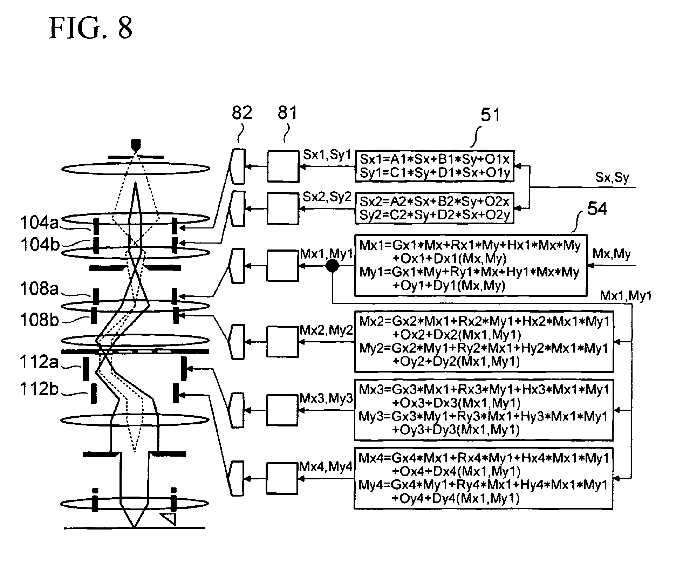

The above-described two-steps of electron beam trajectory adjustment provides the deflection efficiencies of the selective deflectors and the bending back deflectors, and the mask deflection data correction operation section 54 obtains correction expressions such as shown in Fig. 8. As to the voltages to be applied to the electrodes of the first selective deflector 108a, the values (Mx1, My1) obtained by correcting the exposure data (Mx, My) in the mask deflection data operation section 54 are decomposed into eight pieces by an octopolar data decomposer 81, and then converted into analog data by DAC-amplifiers 82 to be supplied to the electrodes, respectively.

As to the second selective deflector 108b and the bending back deflectors 112a and 112b, corrected data to be supplied to the first selective deflector 108a is inputted to the respective mask deflection data correction operation sections 54 to be corrected therein and then outputted.

It should be noted that though a term with a coefficient D is written in each of the correction expressions of Fig. 8, this is a high-order term, and the value thereof hardly changes. Accordingly, this term is not a subject of coefficient calculation in the above description.

As described above, in this embodiment, in the multi-column electron beam exposure apparatus, the deflection efficiencies of the four deflectors involved in the selection of a pattern on the stencil mask are adjusted in a step before the installation of the stencil mask so that the electron beam may be always applied to the same position regardless of the direction in which the electron beam is deflected before being bent back. Further, after the installation of the stencil mask, the deflection efficiency of the selective deflector involved in the selection of the pattern is adjusted so that the pattern on the stencil mask can be accurately selected. This eliminates the necessity of calculating correction data individually for each of the patterns on the stencil mask, and enables electron beam trajectory adjustment to be efficiently performed.

In the above description, a description has been made of one of the column cells of the multi-column electron beam exposure apparatus. However, it is a matter of course that the present invention can be applied not only to a multi-column electron beam exposure apparatus but also to a single-column electron beam exposure apparatus.

(Electron Beam Trajectory Adjustment Method)

Next, an electron beam trajectory adjustment method is described with reference to flowcharts of Figs. 9 to 11. Fig. 9 is a flowchart showing the outline of an electron beam trajectory adjustment process.

First, in step S11, before the installation of a stencil mask, the deflection efficiencies of selective deflectors and bending back deflectors are adjusted, and relative conditions between the deflection efficiencies of the deflectors are determined. For the deflectors involved in the selection of a transmission aperture pattern formed on the stencil mask, electron beam trajectory adjustment is performed so that an electron beam deflected toward any position may be bent back to the same position by the bending back deflector. This trajectory adjustment is performed by adjusting the deflection efficiencies which correct the voltages to be supplied to the deflectors.

Then, in step S12, the stencil mask is installed.

Thereafter, in step S13, with the relative conditions between the deflection efficiencies of the deflectors maintained, a determination is made of the deflection efficiency of a selective deflector to select an aperture pattern on the stencil mask.

Since trajectory adjustment has been performed without the stencil mask in step S11, the deflectors has such a relationship therebetween that the electron beam deflected toward any position is bent back to the same position. Accordingly, if an aperture pattern on the stencil mask can be selected with high accuracy, it is possible to expose the selected aperture pattern (character projection) on a sample with high accuracy.

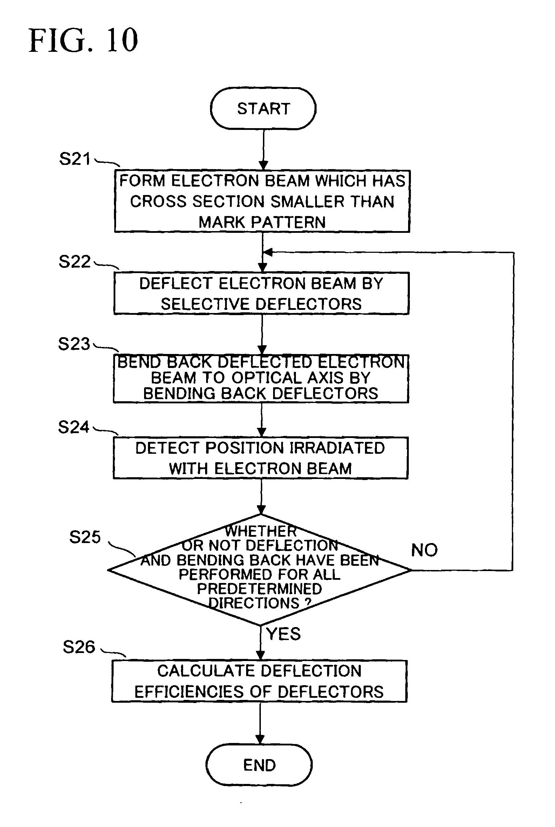

Fig. 10 shows one example of an electron beam trajectory adjustment process before the installation of the stencil mask.

First, in step S21, an electron beam is formed which has a cross section smaller than a mark pattern. Such an electron beam is formed as follows: when the electron beam which has passed through the first aperture of the variable shaping unit is passed through the second aperture, the electron beam is deflected so that the overlap between the apertures may have a required shape.

Then, in step S22, the electron beam is deflected by the selective deflectors. At this time, the electron beam is deflected toward several predetermined positions, for example, four corners of the field onto which the electron beam can be deflected, in order.

Subsequently, in step S23, the deflected electron beam is bent back to the optical axis by the bending back deflectors.

After that, in step S24, the position irradiated with the bent-back electron beam is detected. The irradiation position is detected by mark detection. Specifically, the electron beam is scanned to pass over a mark pattern provided on the target, and the position of the mark pattern is detected and recorded. Moreover, the difference between the detected position of the mark pattern and the actual position of the mark pattern is calculated and recorded.

Then, in step S25, a determination is made as to whether or not deflection and bending back have been performed for all predetermined directions. If deflection and bending back have been performed for all predetermined directions, the flow goes to step S16. If deflection and bending back have not been performed for all predetermined directions, the flow goes back to step S12, and processing is continued for the deflection of the electron beam in other direction.

Subsequently, in step 526, the deflection efficiencies of the deflectors are calculated. The relationship between the differences recorded in step S24 and the amounts of deflection given to the deflectors when the electron beam is deflected in step S22 is substituted into correction expressions (1) to (8) to find expressions necessary for the calculation of the deflection efficiencies. The deflection efficiencies are calculated from these expressions.

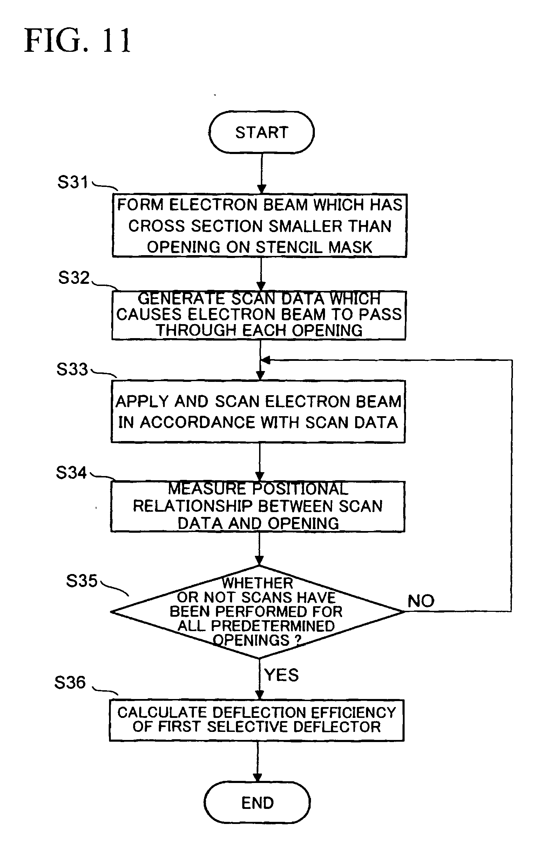

Fig. 11 shows one example of an electron beam trajectory adjustment process after the installation of the stencil mask.

First, in step S31, an electron beam is formed which has a cross section smaller than an opening (transmission aperture mark) on the stencil mask. Such an electron beam is formed as follows: when the electron beam which has passed through the first aperture of the variable shaping unit is passed through the second aperture, the electron beam is deflected so that the overlap between the apertures may have a required shape.

Then, in step S32, scan data is generated which causes the electron beam to pass through each opening. This scan data includes various conditions to scan the electron beam using a first selective deflector: e.g., a scan start position, a scan interval (pitch), and the number of scan points.

Subsequently, in step S33, the electron beam is applied and scanned in accordance with the scan data. At this time, since the deflection efficiencies of the second deflector and the bending back deflectors have already been adjusted, it is guaranteed that the deflected electron beam is bent back to return to the optical axis. Accordingly, reflected electrons are detected when the electron beam passes through an opening, and no reflected electrons are detected when the electron beam does not pass through an opening to be blocked by the stencil mask.

After that, in step S34, the positional relationship between the scan data and the opening is measured. The position at the time when reflected electrons have been detected is assumed to be the position of the opening. This position and the voltage applied at this time are recorded. Moreover, the difference between the position detected when the electron beam has passed through the opening and the actual position of the opening is calculated and recorded.

Then, in step 535, a determination is made as to whether or not scans have been performed for all predetermined openings. For example, a determination is made as to whether or not four openings have been scanned in the X and Y directions. If scans have been performed for all the predetermined openings, the flow goes to step S36. If scans have not been performed for all the predetermined openings, the flow goes back to step S33, and scanning is continued for other opening.

Subsequently, in step S36, the deflection efficiency of the first selective deflector is calculated. For example, in the case where four openings are scanned in the X and Y directions, the relationship between the voltages and differences measured and recorded in step S34 is substituted into correction expressions (1) and (2) to find eight expressions. Eight deflection correction coefficients (deflection efficiency) are calculated from these expressions.

As described above, in the electron beam trajectory adjustment method of this embodiment, the deflection efficiencies of the deflectors involved in the selection of a pattern on the stencil mask are adjusted before the installation of the stencil mask to determine relative conditions between the deflectors so that the electron beam deflected in any direction before being bent back may be applied to the same position on a target. After that, the stencil mask is installed, and the deflection efficiency of the first selective deflector is adjusted so that a pattern on the stencil mask can be accurately selected. As a result, the necessity of calculating correction data individually for each of the patterns on the stencil mask, and enables electron beam trajectory adjustment to be efficiently performed.

## Claims

1. A multi-column electron beam lithography apparatus comprising a plurality of columns to apply electron beams onto a sample, wherein

   each of the columns comprises:

   a stencil mask having a plurality of aperture patterns;
   a selective deflector provided on an incident side of the stencil mask, and configured to deflect the electron beam to select one of the aperture patterns;
   a bending back deflector provided on an exit side of the stencil mask, and configured to bend back to an optical axis of the column the electron beam that has passed through the aperture pattern; and
   an electron beam trajectory adjustment unit configured to:

   adjust deflection efficiencies of the deflectors, without the stencil mask installed, in such a manner as to allow the electron beam deflected toward any positions in a deflection region by the selective deflector to be applied to the same position on the sample by being bent back by the bending back deflector, and
   adjust the deflection efficiency of the selective deflector, with the stencil mask installed, in such a manner as to allow the electron beam to be deflected toward any of the aperture patterns of the stencil mask while maintaining a relationship between the adjusted deflection efficiencies of the deflectors.

2. The multi-column electron beam lithography apparatus according to claim 1, wherein each of the columns further comprises:

a variable shaping unit provided upstream of the selective deflector and configured to shape a cross section of the electron beam; and
a reflected electron detector configured to detect a quantity of electrons reflected from the sample due to irradiation with the electron beam,
wherein the electron beam trajectory adjustment unit comprises:

a mask deflection data correction operation section connected to the selective and bending back deflectors, and configured to correct data on a deflection position on the stencil mask;
a mask scan data generation section connected to the mask deflection data correction operation section, and configured to generate data to scan the stencil mask with the electron beam; and
a scan waveform analysis section configured to accumulate a reflected electron signal of the reflected electron detector and to analyze a waveform of the reflected electron signal, and

without the stencil mask installed, the electron beam trajectory adjustment unit causes the variable shaping unit to shape the electron beam in such a manner as to allow the electron beam to have a cross section smaller than a mark pattern provided on the sample; causes the selective deflector to deflect the electron beam in a plurality of different directions and causes the bending back deflector to bend back each of the electron beams deflected in the plurality of different directions; applies and scans the electron beam onto the mark pattern provided on the sample to detect a position of the mark pattern; and adjusts the deflection efficiencies of the selective and bending back deflectors in such a manner as to allow all the detected positions of the mark pattern to be detected at the same position.

3. The multi-column electron beam lithography apparatus according to claim 1, wherein with the stencil mask installed, the electron beam trajectory adjustment unit causes the variable shaping unit to shape the electron beam into a beam having a cross section smaller than each of aperture mark patterns for electron beam trajectory adjustment formed on the stencil mask; for each of the plurality of aperture mark patterns for electron beam trajectory adjustment formed on the stencil mask, scans the resultant electron beam based on data generated to allow the electron beam to scan and pass through the aperture mark pattern, and calculates a positional relationship between the data and the aperture mark pattern for electron beam trajectory adjustment on the stencil mask, on the basis of information on electrons reflected from the target; and determines the deflection efficiency of the selective deflector to allow the electron beam to select any aperture pattern from all the aperture patterns of the stencil mask.

4. The multi-column electron beam lithography apparatus according to any one of claims 2 and 3, wherein the variable shaping unit comprises:

a first mask having a first rectangular aperture to shape the electron beam;
a second mask having a second rectangular aperture to shape the electron beam; and
a variable rectangular shaping deflector disposed between the first and second masks, and configured to deflect the electron beam.

5. An electron beam trajectory adjustment method for a multi-column electron beam lithography apparatus including a plurality of columns to apply electron beams onto a sample, the method comprising the steps of, in each of the columns:

before installation of a stencil mask, determining relative conditions between deflection efficiencies of a selective deflector and a bending back deflector by adjusting the deflection efficiencies of the deflectors in such a manner as to allow the electron beam deflected in any directions to be applied to the same position;
installing the stencil mask; and
after the installation of the stencil mask, applying the electron beam while maintaining the relative conditions between the deflection efficiencies of the deflectors, and determining the deflection efficiency of the selective deflector to allow the electron beam to select any aperture pattern from all aperture patterns on the stencil mask.

6. The electron beam trajectory adjustment method according to claim 5, wherein the step of determining the relative conditions between the deflection efficiencies before the installation of the stencil mask comprises:

forming an electron beam having a cross-sectional area smaller than a mark pattern provided on the sample;
causing the selective deflector to deflect the electron beam in a plurality of different directions and causing the bending back deflector to bend back each of the electron beams deflected in the plurality of different directions;
applying and scanning each of the electron beams onto the mark pattern provided on the sample to detect a position of the mark pattern provided on the sample; and
adjusting the deflection efficiencies of the selective and bending back deflectors in such a manner as to allow the electron beams deflected in the different directions and then bent back to detect the same position as a position of the mark pattern provided on the sample.

7. The electron beam trajectory adjustment method according to claim 5, wherein
the step of determining the deflection efficiency of the selective deflector after the installation of the stencil mask comprises:

forming an electron beam having a cross-sectional area smaller than each of aperture mark patterns for electron beam trajectory adjustment which are formed on the stencil mask;
generating data to allow the electron beam to scan and pass through each of the aperture mark patterns for electron beam trajectory adjustment;
detecting electrons reflected from the sample by scanning the electron beam based on all the generated data;
calculating a positional relationship between the data and the aperture mark pattern for electron beam trajectory adjustment on the stencil mask; and
determining the deflection efficiency of the selective deflector to allow the electron beam to select any aperture pattern from all the aperture patterns of the stencil mask.

## Patentansprüche

1. Mehrsäulen-Elektronenstrahllithographiegerät, enthaltend eine Vielzahl von Säulen, um Elektronenstrahlen auf eine Probe zu applizieren, wobei
jede der Säulen enthält:

eine Lochmaske, die eine Vielzahl von Aperturmustern aufweist,
einen Auswahldeflektor, der an einer Einfallseite der Lochmaske angeordnet ist und dazu geeignet ist, den Elektronenstrahl abzulenken, um eines der Aperturmuster auszuwählen,
ein Rückbeugungsdeflektor, der an einer Austrittsseite der Lochmaske angeordnet ist und dazu geeignet ist, den Elektronenstrahl, der durch das Aperturmuster gelaufen ist, zu einer optischen Achse der Säule zurückzubeugen, und
eine Elektronenstrahltrajektorien-Einstelleinheit, die dazu geeignet ist:

Ablenkleistungen der Deflektoren einzustellen, ohne installierte Lochmaske, auf solche Art und Weise, dass ermöglicht wird, dass der durch den Auswahldeflektor zu irgendwelchen Positionen in einen Ablenkbereich abgelenkte Elektronenstrahl durch Zurückbeugen durch den Rückbeugungsdeflektor auf dieselbe Position auf der Probe appliziert wird, und
die Ablenkleistung des Auswahldeflektors einzustellen, mit installierter Lochmaske, auf solche Art und Weise, dass ermöglicht wird, dass der Elektronenstrahl durch den Auswahldeflektor zu irgendeinem der Aperturmuster der Lochmaske abgelenkt wird, während eine Beziehung zwischen den eingestellten Ablenkleistungen der Deflektoren aufrechterhalten wird.

2. Mehrsäulen-Elektronenstrahllithographiegerät nach Anspruch 1, bei dem
jede der Säulen ferner enthält:

eine variable Formungseinheit, die dem Auswahldeflektor vorgelagert und dazu geeignet ist, einen Querschnitt des Elektronenstrahls zu formen, und
einen Reflektierte-Elektronen-Detektor, der dazu geeignet ist, eine Quantität an von der Probe infolge der Bestrahlung mit dem Elektronenstrahl reflektierten Elektronen zu erfassen,
wobei die Elektronenstrahltrajektorien-Einstelleinheit enthält:

eine Maskenablenkdatenkorrektursektion, die an den Auswahl- und den Rückbeugungsdeflektor angeschlossen und so konfiguriert ist, dass sie Daten über eine Ablenkposition auf der Lochmaske korrigiert,

eine Maskenrasterdatenerzeugungssektion, die an die Maskenablenkdatenkorrektursektion angeschlossen und so konfiguriert ist, dass sie die Lochmaske mit dem Elektronenstrahl abrastert, und

eine Rastersignalformanalysesektion, die dazu geeignet ist, ein Reflektierte-Elektronen-Signal vom Reflektierte-Elektronen-Detektor aufzunehmen und eine Signalform des Reflektierte-Elektronen-Signals zu analysieren, und

wobei, ohne installierte Lochmaske, die Elektronenstrahltrajektorien-Einstelleinheit veranlasst, dass die variable Formungseinheit den Elektronenstrahl auf solche Art und Weise formt, dass ermöglicht wird, dass der Elektronenstrahl einen kleineren Querschnitt als ein auf der Probe vorgesehenes Markierungsmuster aufweist, veranlasst, dass der Auswahldeflektor den Elektronenstrahl in eine Vielzahl von unterschiedlichen Richtungen ablenkt, und veranlasst, dass der Rückbeugungsdeflektor jeden der in die Vielzahl von unterschiedlichen Richtungen abgelenkten Elektronenstrahlen zurückbeugt, den Elektronenstrahl auf das auf der Probe vorgesehene Markierungsmuster appliziert und rastert und die Ablenkleistungen des Auswahl- und des Rückbeugungsdeflektors auf solche Art und Weise einstellt, dass ermöglicht wird, dass alle erfassten Positionen des Markierungsmusters an derselben Position erfasst werden.

3. Mehrsäulen-Elektronenstrahllithographiegerät nach Anspruch 1, bei dem, mit installierter Lochmaske, die Elektronenstrahltrajektorien-Einstelleinheit veranlasst, dass die variable Formungseinheit den Elektronenstrahl in einen Elektronenstrahl formt, der einen kleineren Querschnitt aufweist, als jedes der auf der Lochmaske ausgebildete Aperturmarkierungsmuster zur Elektronenstrahltrajektorieneinstellung, den sich ergebenden Elektronenstrahl für jedes aus der Vielzahl von auf der Lochmaske ausgebildeten Aperturmarkierungsmustem zur Elektronenstrahltrajektorieneinstellung auf der Grundlage von Daten rastert, die erzeugt wurden, um zu ermöglichen, dass der Elektronenstrahl das Aperturmarkierungsmuster abrastert und durch es hindurchläuft und auf der Grundlage von Information über vom Ziel reflektierten Elektronen einen Positionszusammenhang zwischen den Daten und dem Aperturmarkierungsmuster zur Elektronenstrahltrajektorieneinstellung berechnet, und die Ablenkleistung des Auswahldeflektors bestimmt, um zu ermöglichen, dass der Elektronenstrahl irgendein Aperturmuster aus allen Aperturmustern der Lochmaske auswählt.

4. Mehrsäulen-Elektronenstrahllithographiegerät nach einem der Ansprüche 2 oder 3, bei dem die variable Formungseinheit enthält:

eine erste Maske, die eine erste rechteckige Blende aufweist, um den Elektronenstrahl zu formen, eine zweite Maske, die eine zweite rechteckige Blende aufweist, um den Elektronenstrahl zu formen, und einen variablen Rechteck-Formungsdeflektor, der zwischen der ersten und zweiten Maske angeordnet und dazu geeignet ist, den Elektronenstrahl abzulenken.

5. Elektronenstrahlbahn-Einstellverfahren für ein Mehrsäulen-Elektronenstrahllithographiegerät, enthaltend eine Vielzahl von Säulen, um Elektronenstrahlen auf eine Probe zu applizieren, wobei das Verfahren die folgenden Schritte umfasst, in jeder Säule:

vor Installation der Lochmaske, Bestimmen von Relativbedingungen zwischen Ablenkleistungen eines Auswahldeflektors und eines Rückbeugungsdeflektors durch Einstellen der Ablenkleistungen der Deflektoren auf solche Art und Weise, dass ermöglicht wird, dass der in irgendwelche Richtungen abgelenkte Elektronenstrahl auf dieselbe Position appliziert wird,
Installieren der Lochmaske und,
nach Installation der Lochmaske, Applizieren des Elektronenstrahls, während die Relativbedingungen zwischen den Ablenkleistungen der Deflektoren aufrechterhalten werden, und Bestimmen der Ablenkleistung des Auswahldeflektors, um zu ermöglichen, dass der Elektronenstrahl irgendein Aperturmuster aus allen Aperturmustern auf der Lochmaske auswählt.

6. Elektronenstrahlbahn-Einstellverfahren nach Anspruch 5, bei dem der Schritt des Bestimmens der Relativbedingungen zwischen den Ablenkleistungen vor der Installation der Lochmaske umfasst:

Formen eines Elektronenstrahls, der eine Querschnittfläche aufweist, die kleiner ist als ein auf der Probe vorgesehenes Markierungsmuster,
Veranlassen, dass der Auswahldeflektor den Elektronenstrahl in eine Vielzahl von unterschiedlichen Richtungen ablenkt, und Veranlassen, dass der Rückbeugungsdeflektor jeden der in die Vielzahl von unterschiedlichen Richtungen abgelenkten Elektronenstrahlen zurückbeugt,
Applizieren und Rastern eines jeden der Elektronenstrahlen auf das auf der Probe vorgesehene Markierungsmuster, um eine Position des auf der Probe vorgesehenen Markierungsmusters zu erfassen, und
Einstellen der Ablenkleitungen des Auswahl- und des Rückbeugungsdeflektors auf solche Art und Weise, dass ermöglicht wird, dass die in die unterschiedlichen Richtungen abgelenkten und dann zurückgebeugten Elektronenstrahlen dieselbe Position als Position des auf der Probe vorgesehenen Markierungsmusters erfassen.

**7.** Elektronenstrahlbahn-Einstellverfahren nach Anspruch 5, bei dem
der Schritt des Bestimmens der Ablenkleistung des Auswahldeflektors nach der Installation der Lochmaske umfasst:

Formen eines Elektronenstrahls, der eine Querschnittfläche aufweist, die kleiner ist als jedes der auf der Lochmaske ausgebildeten Aperturmarkierungsmuster zur Elektronenstrahltraj ektorieneinstellung,
Erzeugen von Daten, die ermöglichen, dass der Elektronenstrahl jedes Aperturmarkierungsmuster zur Elektronenstrahltrajektorieneinstellung abrastert und durch es hindurchläuft,
Erfassen von Elektronen, die von der Probe durch Rastern des Elektronenstrahls reflektiert werden, auf der Grundlage aller erzeugten Daten,
Berechnen eines Positionszusammenhangs zwischen den Daten und dem Aperturmarkierungsmuster zur Elektronenstrahltrajektorieneinstellung auf der Lochmaske und
Bestimmen der Ablenkleistung des Auswahldeflektors, um zu ermöglichen, dass der Elektronenstrahl irgendein Aperturmuster aus all den Aperturmustern der Lochmaske auswählt.

## Revendications

**1.** Appareil de lithographie à faisceau d'électrons multi-colonne, comprenant une série de colonnes pour appliquer les faisceaux d'électrons sur un échantillon, où
chacune des colonnes comprend :

un masque stencil ayant une série de motifs d'ouverture ;
un déflecteur sélectif placé sur le côté incident du masque stencil, et configuré pour dévier le faisceau d'électrons pour sélectionner l'un des motifs d'ouverture ;
un déflecteur de re-déviation placé sur le côté de sortie du masque stencil, et configuré pour re-dévier l'axe optique de la colonne du faisceau d'électrons qui est passé par le motif d'ouvertures, et
une unité d'ajustement de la trajectoire du faisceau d'électrons, configurée pour :

ajuster les efficacités de déflection des déflecteurs, sans le masque stencil installé, de telle sorte que l'on permette au faisceau d'électrons dévié vers une position quelconque dans une région de déflection par le déflecteur sélectif, d'être envoyé sur la même position que l'échantillon en étant re-dévié par le déflecteur de re-déviation, et
ajuster l'efficacité de déflexion du déflecteur sélectif, avec le masque stencil installé, de telle sorte que l'on permette au faisceau d'électrons d'être dévié vers l'un quelconque des motifs d'ouverture du masque stencil en maintenant une relation entre les efficacités de déflexion ajustées des déflecteurs.

**2.** Appareil de lithographie à faisceau d'électrons multi-colonne selon la revendication 1, où
chacune des colonnes comprend en outre :

une unité de mise en forme placée en amont du déflecteur sélectif et configuré pour mettre en forme la coupe transversale du faisceau d'électrons, et
un détecteur d'électron réfléchi configuré pour détecter une quantité d'électrons réfléchis par l'échantillon suite à l'irradiation avec le faisceau d'électrons,
où l'unité d'ajustement de la trajectoire du faisceau d'électrons comprend :

une section de correction des données de déflexion du masque, connectée aux déflecteurs sélectif et de re-déviation, et configurée pour corriger les données sur la position de déflexion du masque stencil ;
une section de génération de données de balayage du masque, connectée à la section de correction des données de déflexion du masque, et configurée pour générer des données pour balayer le masque stencil avec le faisceau d'électrons, et
une section d'analyse de la forme d'onde du balayage, configurée pour accumuler un signal électronique réfléchi du détecteur d'électrons réfléchis et pour analyser la forme d'onde du signal électronique réfléchi, et
sans le masque stencil installé, l'unité d'ajustement de la trajectoire du faisceau électronique induit l'unité de mise en former à agir sur le faisceau d'électrons de telle sorte que l'on permette au faisceau d'électrons d'avoir une coupe transversale inférieure à un motif de marquage prévu sur l'échantillon ; induit le déflecteur sélectif à dévier le faisceau électronique dans une série de directions différentes et à induire le déflecteur de re-déviation à re-dévier chacun des faisceaux électroniques déviés dans la série des directions différentes ; applique et balaie le faisceau d'électrons sur le motif de marquage prévu sur l'échantillon pour détecter la position du motif de marquage, et ajuste les efficacités de déflexion des déflecteurs sélectif et de re-déviation de telle sorte que cela permette à toutes les positions détectées du motif de marquage d'être détectées à la même position.

3. Appareil de lithographie à faisceau d'électrons multi-colonne selon la revendication 1, où avec le masque stencil installé, l'unité d'ajustement de la trajectoire du faisceau d'électrons induit l'unité de mise en forme à façonner le faisceau électronique en un faisceau ayant une coupe transversale inférieure à chacun des motifs de marquage pour ajuster la trajectoire du faisceau d'électrons formé sur le masque stencil ; pour chacun de la série des motifs de marquage pour l'ajustement de la trajectoire du faisceau d'électrons formé sur le masque stencil, balaie le faisceau d'électrons résultant sur base des données générées pour permettre au faisceau d'électrons de balayer et de passer au travers du motif de marquage, et calcule la relation de position entre les données et le motif de marquage pour l'ajustement de la trajectoire du faisceau d'électrons sur le masque stencil, sur base de l'information sur les électrons réfléchis par la cible, et détermine l'efficacité de déflexion du déflecteur sélectif pour permettre au faisceau d'électrons de sélection un motif d'ouvertures quelconque parmi tous les motifs d'ouvertures du masque stencil.

4. Appareil de lithographie à faisceau d'électrons multi-colonne selon l'une quelconque des revendications 2 et 3, où l'unité de mise en forme comprend :

un premier masque ayant une première ouverture rectangulaire pour façonner le faisceau d'électrons ; un deuxième masque ayant une deuxième ouverture rectangulaire pour façonner le faisceau d'électrons ; et un déflecteur rectangulaire variable disposé entre le premier et le deuxième masque, et configuré pour dévier le faisceau d'électrons.

5. Procédé d'ajustement de la trajectoire d'un faisceau d'électrons pour un appareil de lithographie à faisceau d'électrons multi-colonne, comprenant une série de colonnes pour appliquer des faisceaux d'électrons sur un échantillon, le procédé comprenant les étapes de, pour chacune des colonnes :

avant installation d'un masque stencil, détermination des conditions relatives entre les efficacités de déflexion d'un déflecteur sélectif et d'un déflecteur de re-déviation par ajustement des efficacités de déflexion des déflecteurs de telle sorte que l'on permette au faisceau d'électrons d'être dévié dans n'importe quelle direction pour être appliqué sur la même position ; installation du masque stencil, et après installation du masque stencil, application du faisceau d'électrons en maintenant les conditions relatives entre les efficacités de déflexion des déflecteurs, et détermination de l'efficacité de déflexion du déflecteur sélectif pour permettre au faisceau d'électrons de sélectionner un motif d'ouvertures quelconque parmi tous les motifs d'ouvertures sur le masque stencil.

6. Procédé d'ajustement de la trajectoire d'un faisceau d'électrons selon la revendication 5, où l'étape de détermination des conditions relatives entre les efficacités de déflexion avant l'installation du masque stencil comprend les étapes consistant à :

former un faisceau d'électrons ayant une surface de coupe transversale inférieure à un motif de marquage prévu sur l'échantillon ; induire le déflecteur sélectif à dévier le faisceau d'électrons en une série de directions différentes et induire le déflecteur de re-déviation à re-dévier chacun des faisceaux d'électrons déviés dans la série des directions différentes ; appliquer et balayer chacun des faisceaux d'électrons sur le motif de marquage prévu sur l'échantillon pour détecter la position du motif de marquage sur l'échantillon, et ajuster les efficacités de déflexion des déflecteurs sélectif et de re-déviation de telle sorte que l'on permette au faisceau d'électrons dévié dans les différentes directions puis re-dévié, de détecter la même position que celle du motif de marquage sur l'échantillon.

**7.** Procédé d'ajustement de la trajectoire d'un faisceau d'électrons selon la revendication 5, où l'étape de détermination de l'efficacité de déflexion du déflecteur sélectif après l'installation du masque stencil comprend les étapes consistant à :

former un faisceau d'électrons ayant une surface de coupe transversale inférieure à chaque motif de marquage pour l'ajustement de la trajectoire du faisceau d'électrons, qui sont formés sur le masque stencil ;

générer des données pour permettre au faisceau électronique de balayer et de passer au travers de chacun des motifs de marquage pour l'ajustement de la trajectoire du faisceau électronique ;

détecter les électrons réfléchis par l'échantillon en balayant le faisceau électronique sur base de toutes les données générées ;

calculer la relation de position entre les données et le motif de marquage pour l'ajustement de la trajectoire du faisceau électronique sur le masque stencil, et

déterminer l'efficacité de déflexion du déflecteur sélectif pour permettre au faisceau d'électrons de sélectionner un motif d'ouverture quelconque parmi tous les motifs d'ouverture sur le masque stencil.

# FIG. 1

INTEGRATION CONTROL SYSTEM ~26

20

ELECTRON GUN HIGH-VOLTAGE POWER SOURCE ~21

LENS POWER SOURCE ~22

DIGITAL CONTROLLER ~23

DIGITAL CONTROLLER ~23

STAGE DRIVE CONTROLLER ~24

STAGE POSITION SENSOR ~25

10

11

11

11

12

13

# FIG. 2

26

INTEGRATION CONTROL SYSTEM

31

35 36 37

31

35 36 37

11 11

. . . .

31

35 36 37

INTEGRATION STORAGE

33

34

12

# FIG. 3

FIG. 4

111

TM4

TM3

TM1

TM2

| 88 | 87 | 86 | 85 | 84 | 83 | 82 |
| 98 | 66 | 65 | 64 | 63 | 62 | 61 | 60 | 97 |
| | 42 | 41 | 40 | 39 | 38 | 37 | 36 |
| | 43 | 20 | 19 | 18 | 17 | 16 | 35 |
| 89 | 67 | 44 | 21 | 6 | 5 | 4 | 15 | 34 | 59 | 81 | 96 |
| 90 | 68 | 45 | 22 | 7 | 0 | 3 | 14 | 33 | 58 | 80 | 95 |
| 91 | 69 | 46 | 23 | 8 | 1 | 2 | 13 | 32 | 57 | 79 | 94 |
| 92 | 70 | 47 | 24 | 9 | 10 | 11 | 12 | 31 | 56 | 78 | 93 |
| | 48 | 25 | 26 | 27 | 28 | 29 | 30 |
| | 49 | 50 | 51 | 52 | 53 | 54 | 55 |
| 71 | 72 | 73 | 74 | 75 | 76 | 77 |
| | | 99 |

EP 2 388 801 B1

# FIG. 5

61

FIRST
RECTANGULAR
APERTURE

63 SECOND
RECTANGULAR
APERTURE

62

108a

108b

65a

64a

112a

64b

65b

112b

ROUND
APERTURE

REFLECTED
ELECTRON
DETECTOR

TARGET MARK

FIG. 6A

61

63

62

108a

108b

66

67d 67c

111

112a

67a 67b

112b

ROUND
APERTURE

REFLECTED
ELECTRON
DETECTOR

T

FIG. 6B

## FIG. 7

71

X

EB2

EB1

72

73

x1    x2

# FIG. 8

82    81                          51

Sx1,Sy1    Sx1=A1*Sx+B1*Sy+O1x
           Sy1=C1*Sy+D1*Sx+O1y          Sx,Sy

Sx2,Sy2    Sx2=A2*Sx+B2*Sy+O2x
           Sy2=C2*Sy+D2*Sx+O2y          54

104a
104b

Mx1,My1    Mx1=Gx1*Mx+Rx1*My+Hx1*Mx*My    Mx,My
           +Ox1+Dx1(Mx,My)
           My1=Gx1*My+Ry1*Mx+Hy1*Mx*My
           +Oy1+Dy1(Mx,My)
                                          Mx1,My1
108a
108b

Mx2,My2    Mx2=Gx2*Mx1+Rx2*My1+Hx2*Mx1*My1
           +Ox2+Dx2(Mx1,My1)
           My2=Gx2*My1+Ry2*Mx1+Hy2*Mx1*My1
           +Oy2+Dy2(Mx1,My1)
112a
112b
Mx3,My3    Mx3=Gx3*Mx1+Rx3*My1+Hx3*Mx1*My1
           +Ox3+Dx3(Mx1,My1)
           My3=Gx3*My1+Ry3*Mx1+Hy3*Mx1*My1
           +Oy3+Dy3(Mx1,My1)

Mx4,My4    Mx4=Gx4*Mx1+Rx4*My1+Hx4*Mx1*My1
           +Ox4+Dx4(Mx1,My1)
           My4=Gx4*My1+Ry4*Mx1+Hy4*Mx1*My1
           +Oy4+Dy4(Mx1,My1)

# FIG. 9

```
        ┌─────────────┐
        │    START    │
        └─────────────┘
               │
               ▼
```

S11
┌──────────────────────────────────────┐
│ ADJUST DEFLECTION EFFICIENCIES OF     │
│ SELECTIVE DEFLECTORS AND BENDING      │
│ BACK DEFLECTORS, AND DETERMINE        │
│ RELATIVE CONDITIONS BETWEEN           │
│ DEFLECTION EFFICIENCIES OF            │
│ DEFLECTORS, BEFORE INSTALLATION OF    │
│ STENCIL MASK                          │
└──────────────────────────────────────┘
               │
               ▼

S12
┌──────────────────────────────────────┐
│          INSTALL STENCIL MASK         │
└──────────────────────────────────────┘
               │
               ▼

S13
┌──────────────────────────────────────┐
│ DETERMINE DEFLECTION EFFICIENCY       │
│ OF SELECTIVE DEFLECTOR FOR            │
│ SELECTING APERTURE PATTERN ON         │
│ STENCIL MASK MAINTAINING RELATIVE     │
│ CONDITIONS BETWEEN DEFLECTION         │
│ EFFICIENCIES OF DEFLECTORS            │
└──────────────────────────────────────┘
               │
               ▼
        ┌─────────────┐
        │     END     │
        └─────────────┘
```

# FIG. 10

```
            ( START )
                │
                ▼
S21 ── FORM ELECTRON BEAM WHICH HAS
       CROSS SECTION SMALLER THAN
              MARK PATTERN
                │
                ▼
S22 ──  DEFLECT ELECTRON BEAM BY
          SELECTIVE DEFLECTORS
                │
                ▼
S23 ── BEND BACK DEFLECTED ELECTRON
         BEAM TO OPTICAL AXIS BY
        BENDING BACK DEFLECTORS
                │
                ▼
S24 ──  DETECT POSITION IRRADIATED
          WITH ELECTRON BEAM
                │
                ▼
          WHETHER
       OR NOT DEFLECTION
S25 ── AND BENDING BACK HAVE BEEN ──── NO
         PERFORMED FOR ALL
          PREDETERMINED
          DIRECTIONS ?
                │
               YES
                │
                ▼
S26 ──  CALCULATE DEFLECTION
       EFFICIENCIES OF DEFLECTORS
                │
                ▼
            ( END )
```

# FIG. 11

```
                        ┌──────────┐
                        │  START   │
                        └──────────┘
                              │
                              ▼
S31 ─┐  ┌─────────────────────────────────────┐
     └─►│ FORM ELECTRON BEAM WHICH HAS         │
        │ CROSS SECTION SMALLER THAN           │
        │ OPENING ON STENCIL MASK              │
        └─────────────────────────────────────┘
                              │
                              ▼
S32 ─┐  ┌─────────────────────────────────────┐
     └─►│ GENERATE SCAN DATA WHICH             │
        │ CAUSES ELECTRON BEAM TO PASS         │
        │ THROUGH EACH OPENING                 │
        └─────────────────────────────────────┘
                              │
                              ▼
S33 ─┐  ┌─────────────────────────────────────┐
     └─►│ APPLY AND SCAN ELECTRON BEAM         │
        │ IN ACCORDANCE WITH SCAN DATA         │
        └─────────────────────────────────────┘
                              │
                              ▼
S34 ─┐  ┌─────────────────────────────────────┐
     └─►│ MEASURE POSITIONAL                   │
        │ RELATIONSHIP BETWEEN SCAN            │
        │ DATA AND OPENING                     │
        └─────────────────────────────────────┘
                              │
                              ▼
S35 ─┐           WHETHER
     └─►      OR NOT SCANS HAVE        NO
           ◄  BEEN PERFORMED FOR  ►──────────┐
              ALL PREDETERMINED
                OPENINGS ?
                              │ YES
                              ▼
S36 ─┐  ┌─────────────────────────────────────┐
     └─►│ CALCULATE DEFLECTION EFFICIENCY      │
        │ OF FIRST SELECTIVE DEFLECTOR         │
        └─────────────────────────────────────┘
                              │
                              ▼
                        ┌──────────┐
                        │   END    │
                        └──────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004088071 A
- US 20060214117 A1
- JP 2000091225 A
- JP 5136031 A